# EUROPEAN PATENT APPLICATION

(11) **EP 4 576 963 A1**
(43) Date of publication of application: **25.06.2025**
(21) Application number: 23862033.0
(22) Date of filing: 30.06.2023
(51) Int. Cl.: H05K 7/20, F28D 15/04

(54) **VAPOR CHAMBER, ELECTRONIC DEVICE AND CHIP PACKAGING STRUCTURE**

(30) Priority: 09.09.2022 CN 202211103850
(71) Applicant: Huawei Technologies Co., Ltd., Shenzhen, Guangdong 518129 (CN)
(72) Inventor: VASILIEV, Leonid Leonardovich, Shenzhen, Guangdong 518129 (CN); TAN, Xianghui, Shenzhen, Guangdong 518129 (CN); VIKTAR, Burak, Shenzhen, Guangdong 518129 (CN); ALIAKHNOVICH, Valery, Minsk 220072 (BY)
(74) Representative: Maiwald GmbH
(86) International application number: PCT/CN2023/105384
(87) International publication number: WO 2024/051332

(57) **Abstract**

A vapor chamber (100), an electronic device, and a chip package structure are provided. The vapor chamber (100) includes a housing (1). A cavity (11) is formed in the housing (1), and the cavity (11) contains a coolant. The housing (1) has a first surface (11a) and a second surface (11b) that enclose the cavity (11). A first capillary structure (2) is disposed on both the first surface (11a) and the second surface (11b). The coolant may return from the second surface (11b) to a first part (1b2) of the first surface (11a) through the first capillary structure (2). A second capillary structure (3) is disposed on a second part (1b3) of the first surface (11a). The coolant returning to the first part (1b2) returns to the second part (1b3) through the second capillary structure (3). A capillary force of the first capillary structure (2) is less than a capillary force of the second capillary structure (3). As a result, return resistance to the coolant returning to the second capillary structure (3) through the first capillary structure (2) is relatively low, and a difference between evaporation temperatures of the first part (1b2) and the second part (1b3) is reduced, so that the vapor chamber (100) has a high heat transfer capacity.

## Description

This application claims priority to Chinese Patent Application No. 202211103850.5, filed with the China National Intellectual Property Administration on September 9, 2022 and entitled "VAPOR CHAMBER, ELECTRONIC DEVICE, AND CHIP PACKAGE STRUCTURE", which is incorporated herein by reference in its entirety.

### TECHNICAL FIELD

This application relates to the field of device heat dissipation technologies, and in particular, to a vapor chamber, an electronic device, and a chip package structure.

### BACKGROUND

When a base station, a terminal device (for example, a mobile phone), a routing device, a server, a vehicle-mounted device, or the like works, a high-power-consumption electronic component, such as a chip, disposed inside the device generates a large amount of heat, affecting normal working of the chip. To implement temperature equalization and cooling for the chip, a vapor chamber is installed on the chip. The vapor chamber transfers heat of the chip to a heat sink or air, to implement heat dissipation of the chip.

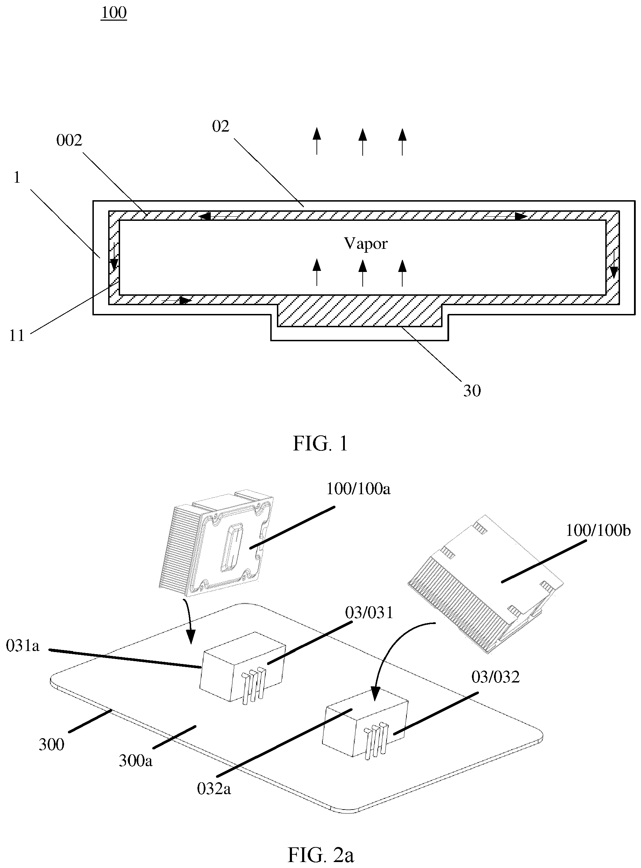

For example, FIG. 1 is a diagram of a structure of a vapor chamber. The vapor chamber 100 includes a housing 1. A cavity 11 is provided in the housing 1, and the cavity 11 is filled with a coolant. A capillary structure 002 is disposed on an inner wall of the cavity 11. A concave groove 30 is provided on an inner surface that is of the cavity 11 and that is close to a heat source, and the concave groove 30 is used as an evaporator. During operation, heat that is input to the evaporator evaporates liquid in a wick on the evaporator. Then, the vapor flows throughout the entire chamber, forming an isothermal heat dissipater. Next, the vapor is condensed at an upper end 02 of the housing 1, and heat is removed through forced convection, natural convection, or liquid cooling. Subsequently, the condensate is returned to the evaporator by capillary force of the capillary structure 002, forming a closed cycle.

However, resistance to the condensate returning to the concave groove 30 through the capillary structure 002 is relatively large, and a temperature difference for temperature equalization is large. This does not help form a heat dissipation cycle.

### SUMMARY

Embodiments of this application provide a vapor chamber, an electronic device, and a chip package structure, to resolve a technical problem that resistance to a coolant returning to an evaporator is relatively large, and a temperature difference for temperature equalization is large, which does not help form a heat dissipation cycle.

To achieve the foregoing objective, the following technical solutions are used in embodiments of this application.

According to a first aspect, a vapor chamber is provided. The vapor chamber includes a substrate, a chip, and a housing. A cavity is formed in the housing, and the cavity contains a coolant. The housing has a first surface and a second surface that enclose the cavity, and the first surface is opposite to the second surface. The first surface includes a first part and a second part, a first capillary structure is disposed on the first part, and a second capillary structure is disposed on the second part. A capillary force of the first capillary structure is less than a capillary force of the second capillary structure, or in a direction perpendicular to the first surface, a thickness of the first capillary structure is greater than a thickness of the second capillary structure. The first capillary structure is disposed on the second surface.

Based on the foregoing description of a structure of the vapor chamber in embodiments of this application, it can be learned that the vapor chamber provided in embodiments of this application includes the housing. The cavity is formed in the housing, and the cavity contains the coolant. The coolant is heated and evaporated, and the vapor flows in the cavity, implementing a function of an isothermal heat dissipater. The housing has the first surface and the second surface that enclose the cavity. The first capillary structure is disposed on both the first surface and the second surface. When the vapor comes into contact with the second surface whose temperature is relatively low, the vapor is rapidly condensed into liquid and heat energy is released. Then, the coolant may return from the second surface to the first part of the first surface through the first capillary structure. The second capillary structure is disposed on the second part of the first surface. The coolant returning to the first part of the first surface returns to the second part through the second capillary structure. The capillary force of the first capillary structure is less than the capillary force of the second capillary structure, but the first capillary structure has a higher permeability than the second capillary structure. As a result, return resistance to the coolant returning to the second capillary structure through the first capillary structure is relatively low. In addition, an equivalent thermal conductivity is increased, so that a difference between evaporation temperatures of the first part and the second part is reduced. Alternatively, in the direction perpendicular to the first surface, the thickness of the first capillary structure is greater than the thickness of the second capillary structure. The thickness of the second capillary structure on the second part is smaller, so that a temperature difference for heat transfer on a surface of the second capillary structure can be reduced during boiling of the coolant, and the return resistance can be reduced. As a result, liquid supply is maintained at a high heat flux, so that the second part has better evaporation performance.

In addition, the thickness of the first capillary structure on the first part is larger, and due to the larger capillary thickness, a larger cross-sectional area can be provided for liquid replenishment, to prevent liquid from being dried out. As a result, the first part has a better capability of transferring the coolant.

In a feasible implementation of the first aspect, in the direction perpendicular to the first surface, the thickness of the first capillary structure is greater than the thickness of the second capillary structure, and a capillary pore size of the first capillary structure is greater than a capillary pore size of the second capillary structure.

As a result, compared with the first capillary structure with the larger capillary pore size, the second capillary structure with the smaller capillary pore size has a larger capillary force, features a larger contact area between particles, and has a higher thermal conductivity. This facilitates return of the coolant.

In a feasible implementation of the first aspect, at least one capillary rib plate is further disposed on the second part.

A plurality of capillary rib plates can increase a channel for the coolant to flow into the second part, thereby reducing resistance to the coolant returning to an evaporator. This helps form a heat dissipation cycle. In addition, the capillary rib plate is disposed on the second part, so that coolant reallocation throughout the second part can be implemented. As a result, a local hot spot (partial dry-out) is avoided on the second part. This facilitates coolant recycling and helps improve a heat dissipation effect.

In a feasible implementation of the first aspect, a capillary pore size of the capillary rib plate is greater than the capillary pore size of the second capillary structure.

Because the plurality of capillary rib plates with the larger capillary pore size have a higher permeability, the capillary rib plates can transfer the coolant to the second part with a relatively small pressure loss.

In a feasible implementation of the first aspect, in the direction perpendicular to the first surface, a thickness of the capillary rib plate is greater than the thickness of the second capillary structure.

In a feasible implementation of the first aspect, a plurality of capillary rib plates are disposed; and the plurality of capillary rib plates are arranged in an array in two mutually perpendicular directions, to form a plurality of grid structures through partitioning on the second part.

A region above the second part is evenly divided into a plurality of sub-regions by arranging the plurality of capillary rib plates into the grid structures, so that even coolant allocation throughout the second part is implemented.

In a feasible implementation of the first aspect, a third capillary structure is disposed on a periphery of the second part, and the third capillary structure extends from the second part toward the second surface; and in an extending direction of the third capillary structure, a thickness of the third capillary structure is greater than the thickness of the first capillary structure disposed on the first part.

Heat source power distribution or thermal load changes with time. Therefore, a temperature may vary throughout the first surface, and the returning coolant may be dried out at a position with a relatively high temperature on the first surface. In this embodiment, the third capillary structure is disposed to reduce dry-out.

In a feasible implementation of the first aspect, a capillary pore size of the third capillary structure is greater than the capillary pore size of the second capillary structure.

In a feasible implementation of the first aspect, the third capillary structure has a third surface away from the second part; and a plurality of buffer posts are disposed on the third surface at intervals, and the buffer post extends toward the second surface.

The buffer post is disposed to increase the channel for the coolant to return to the second part.

In a feasible implementation of the first aspect, a plurality of first capillary posts are further disposed on the second part at intervals; the first capillary post is connected to the first capillary structure on the second surface; and the first capillary post is located at a joint of the plurality of capillary rib plates.

When the capillary rib plate is disposed on the second capillary structure, the first capillary post is provided, and the first capillary post is connected to the first capillary structure on the second surface, to increase the channel for the coolant to return to the second part. As a result, the coolant above the first part can be transferred to the second part. In addition, a part that is of the second capillary structure and on which no capillary rib plate is disposed is used as an effective region for coolant evaporation. The first capillary post being located at the joint of the plurality of capillary rib plates can maximally ensure an area of the effective region for evaporation on the second capillary structure.

In a feasible implementation of the first aspect, a radial dimension of the first capillary post gradually increases from the second part to the second surface.

As a result, when a rate of the returning coolant remains the same, the first capillary post having a larger dimension at an upper end and a smaller dimension at a lower end can maximally ensure the area of the effective region for evaporation on the second capillary structure, thereby ensuring an area of an evaporation and/or boiling region. This contributes to a cooling function of the vapor chamber.

In a feasible implementation of the first aspect, a plurality of second capillary posts are disposed on the first part; and the radial dimension of the first capillary post is less than a radial dimension of the second capillary post.

In a feasible implementation of the first aspect, the second capillary post is connected to the first capillary structure on the second surface.

The second capillary post is disposed to increase the channel for condensate above the second region to return to the second part.

In a feasible implementation of the first aspect, a plurality of first support pillars are further disposed on the second part at intervals; and the first support pillar extends from the second part to the second surface.

The first support pillar is disposed to support the housing and prevent the housing from locally collapsing.

In a feasible implementation of the first aspect, the first support pillar is located in the grid structure.

In a feasible implementation of the first aspect, a radial dimension of the first support pillar gradually increases from the second part to the second surface.

The first support pillar having a larger dimension at an upper end and a smaller dimension at a lower end can maximally ensure an area of an effective region for evaporation on the second capillary structure, thereby ensuring an area of an evaporation and/or boiling region. This contributes to a cooling function of the vapor chamber.

In a feasible implementation of the first aspect, a plurality of second support pillars are disposed on the first part at intervals; and the second support pillar extends from the first part to the second surface.

The second support pillar is disposed to support the housing and prevent the housing from locally collapsing.

In a feasible implementation of the first aspect, a plurality of second capillary posts are disposed on the first part at intervals, and a plurality of second support pillars are disposed on the first part at intervals; and a through hole for accommodating the second support pillar is provided in the second capillary post.

The second support pillar being disposed in the second capillary post can ensure an evaporation area.

In a feasible implementation of the first aspect, at least one groove is provided on the second part, and the at least one groove is configured to contain the coolant.

In a feasible implementation of the first aspect, at least one groove is provided on a surface that is of the capillary rib plate and that is close to the second part, and the at least one groove is configured to contain the coolant.

The groove is provided, and the coolant is provided in the groove. When vapor is generated due to an excessively high temperature, the vapor pushes the coolant in the groove to return to the second part. This liquid recirculation helps avoid a hot spot, especially when the VC operates at a vertical position.

In a feasible implementation of the first aspect, a plurality of grooves are provided; the groove extends in a long-edge direction of the capillary rib plate; and the plurality of grooves are provided side by side in a short-edge direction of the capillary rib plate.

The groove is provided, and the coolant is provided in the groove. When vapor is generated due to an excessively high temperature in the groove, the vapor pushes the coolant in the groove to return to the second part. This liquid recirculation helps avoid the hot spot, especially when the VC operates at the vertical position.

In a feasible implementation of the first aspect, a thickness of the capillary rib plate gradually increases from the second part to the second surface.

The capillary rib plate having a larger dimension at an upper end and a smaller dimension at a lower end can maximally ensure the area of the effective region for evaporation on the second capillary structure, thereby ensuring the area of the evaporation and/or boiling region. This contributes to the cooling function of the vapor chamber.

In a feasible implementation of the first aspect, a concave cavity is provided on the first surface, and the second part includes a bottom surface of the concave cavity.

In a feasible implementation of the first aspect, a chip package structure further includes a heat sink; and the heat sink is disposed on a side that is of the housing and that is close to the second surface.

In a feasible implementation of the first aspect, a thermal conductive layer is disposed between the heat sink and the housing.

According to a second aspect, an electronic device is provided. The electronic device includes a heat generating component and the vapor chamber provided in the first aspect. The vapor chamber is disposed on the heat generating component.

The vapor chamber is configured for the heat generating component in the electronic device, to improve heat dissipation efficiency of the heat generating component and therefore improve performance of the heat generating component.

According to a third aspect, a chip package structure is provided. The chip package structure includes a substrate, a chip, and the vapor chamber provided in the first aspect. The chip is disposed on the substrate. The vapor chamber (vapor chamber) provided in the first aspect is disposed on a side that is of the chip and that is away from the substrate.

As a result, the vapor chamber can dissipate heat for the chip, thereby improving performance of the chip.

### BRIEF DESCRIPTION OF DRAWINGS

FIG. 1 is a diagram of a structure of a vapor chamber;
FIG. 2a is a diagram of a structure of an electronic device according to an embodiment of this application;
FIG. 2b is a diagram of a structure of a chip package structure according to an embodiment of this application;
FIG. 3a is a schematic exploded view of a vapor chamber according to an embodiment of this application;
FIG. 3b is a diagram of a structure of the assembled vapor chamber shown in FIG. 3a;
FIG. 4 is a diagram of a structure of a lower cover of the vapor chamber shown in FIG. 3b;
FIG. 5 is a diagram of a structure of a capillary structure of the vapor chamber shown in FIG. 3b;
FIG. 6 is a diagram of a structure of a capillary structure of the vapor chamber shown in FIG. 3b;
FIG. 7 is a diagram of a structure of a capillary structure of the vapor chamber shown in FIG. 3b;
FIG. 8a is a diagram of a structure of an implementation of a plurality of capillary rib plates of the vapor chamber shown in FIG. 3b;
FIG. 8b is a top view of another implementation of a plurality of capillary rib plates in a vapor chamber according to an embodiment of this application;
FIG. 8c is a top view of still another implementation of a plurality of capillary rib plates in a vapor chamber according to an embodiment of this application;
FIG. 8d is a top view of yet another implementation of a plurality of capillary rib plates in a vapor chamber according to an embodiment of this application;
FIG. 8e is a top view of still yet another implementation of a plurality of capillary rib plates in a vapor chamber according to an embodiment of this application;
FIG. 8f is a top view of a further implementation of a plurality of capillary rib plates in a vapor chamber according to an embodiment of this application;
FIG. 9 is a diagram of a structure of a capillary structure of the vapor chamber shown in FIG. 3b;
FIG. 10 is a diagram of a structure of a capillary structure of a vapor chamber according to an embodiment of this application;
FIG. 11 is a diagram of a structure of a capillary structure of a vapor chamber according to an embodiment of this application;
FIG. 12 is a diagram of a structure of a support pillar of a vapor chamber according to an embodiment of this application;
FIG. 13 is a diagram of structures of a capillary structure and support pillars of a vapor chamber according to an embodiment of this application;
FIG. 14 is a diagram of a structure of an embodiment of grooves of a vapor chamber according to an embodiment of this application;
FIG. 15 is a diagram of a structure of another embodiment of grooves of a vapor chamber according to an embodiment of this application;
FIG. 16 is a diagram of a structure of another embodiment of grooves of a vapor chamber according to an embodiment of this application;
FIG. 17 is a diagram of a structure of a vapor chamber according to an embodiment of this application;
FIG. 18 is a diagram of a structure of the assembled vapor chamber shown in FIG. 17;
FIG. 19 is a diagram of a structure of a lower cover of the vapor chamber shown in FIG. 17;
FIG. 20 is a diagram of a structure of a capillary structure of the vapor chamber shown in FIG. 17; and
FIG. 21 is a diagram of a structure of a vapor chamber according to an embodiment of this application.

### Reference numerals:

100-vapor chamber, 100a-first vapor chamber, 100b-second vapor chamber, 02-upper end, 03-heat generating component, 03 1-first heat generating component, 031a-side end face, 032-second heat generating component, 032a-upper end face, 30-concave groove, 05-substrate, 1-housing, 1a-upper cover, 1b-lower cover, 1b1-accommodating space, 1b2-first part, 1b3-second part, 01-liquid injection port, 11-cavity, 11a-first surface, 11b-second surface, 1c-concave cavity, 1c1-bottom surface, 2-first capillary structure, 2a-first capillary layer, 2b-second capillary layer, 2c-first capillary post, 2d-second capillary post, 2d1-capillary pore, 3-second capillary structure, 301-first sub-region, 302-second sub-region, 4-capillary rib plate, 4a1-first horizontal plate, 4a2-second horizontal plate, 4a3-third horizontal plate, 4a4-fourth horizontal plate, 4b1-first vertical plate, 4b2-first vertical plate, 401-first vapor region, 402-second vapor region, 403-third vapor region, 5-third capillary structure, 5a-through hole, 5b-third surface, 5c-buffer post, 6-support pillar, 6b-first support pillar, 6a-second support pillar, 7-groove, 8-heat sink, 9-fastener, 10a-first installation hole, 10b-second installation hole, 200-chip, 300-circuit board, 300a-upper surface.

### DESCRIPTION OF EMBODIMENTS

The following describes the technical solutions in embodiments of this application with reference to the accompanying drawings in embodiments of this application. In the descriptions of this application, unless otherwise specified, "/" indicates that an "or" relationship between associated objects. For example, A/B may indicate A or B. In this application, "and/or" merely describes an association relationship between associated objects and indicates that three relationships may exist. For example, A and/or B may indicate the following three cases: Only A exists, both A and B exist, and only B exists, where A and B may be singular or plural. In addition, in the descriptions of this application, "a plurality of" means two or more than two unless otherwise specified. "At least one of the following items (pieces)" or a similar expression thereof means any combination of these items, including a single item (piece) or any combination of a plurality of items (pieces). For example, at least one of the following items (pieces): a, b, or c may indicate: a, b, c, a and b, a and c, b and c, or a, b, and c, where a, b, and c may be singular or plural. In addition, to clearly describe the technical solutions in embodiments of this application, terms such as "first" and "second" are used in embodiments of this application to distinguish between same items or similar items that provide basically same functions or purposes. Persons skilled in the art may understand that the terms such as "first" and "second" do not limit a quantity or an execution sequence, and the terms such as "first" and "second" do not indicate a definite difference. In addition, in embodiments of this application, terms such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, the terms such as "example" or "for example" used herein are intended to present a related concept in a specific manner for ease of understanding.

An embodiment of this application provides an electronic device. The electronic device may be a base station device, a terminal device (for example, a mobile phone), a routing device, a server, or a vehicle-mounted device. A specific form of the electronic device is not specially limited in embodiments of this application.

The following describes the electronic device provided in this application with reference to the accompanying drawings.

FIG. 2a is a diagram of a structure of an electronic device according to an embodiment of this application. As shown in FIG. 2a, the electronic device includes heat generating components 03 and vapor chambers 100, where the vapor chamber 100 is disposed on the heat generating component 03.

The vapor chambers 100 may be disposed in two manners.

As shown in FIG. 2a, the heat generating components 03 include a first heat generating component 031 and a second heat generating component 032, and the vapor chambers 100 include a first vapor chamber 100a and a second vapor chamber 100b.

The first vapor chamber 100a is configured to dissipate heat for the first heat generating component 031. The first vapor chamber 100a is perpendicularly disposed, and is fastened to a side end face 031a of the first heat generating component 031.

The second vapor chamber 100b is configured to dissipate heat for the second heat generating component 032. The second vapor chamber 100b is horizontally disposed, and is fastened to an upper end face 032a of the second heat generating component 032.

As shown in FIG. 2a, in some embodiments, the electronic device further includes a circuit board 300, and the heat generating components 03 are disposed on an upper surface 300a of the circuit board 300.

In some embodiments, the vapor chamber 100 and the heat generating component 03 may be connected to each other through a thermal interface material (thermal interface material, TIM) layer 04.

The heat generating component 03 may be a chip or a circuit board. A type of the heat generating component is not limited in this application.

As a thermal conductive component, the vapor chamber 100 is provided with a circulating medium, such as a coolant, and can dissipate heat into air through a series of heat exchanges to implement heat dissipation. The vapor chamber 100 provided in this embodiment of this application features a small size and rapid heat dissipation, and can meet a relatively high heat dissipation requirement of the electronic device.

It may be understood that FIG. 2a schematically shows only some components included in the electronic device, and actual shapes, actual sizes, actual positions, and actual structures of these components are not limited by FIG. 2a.

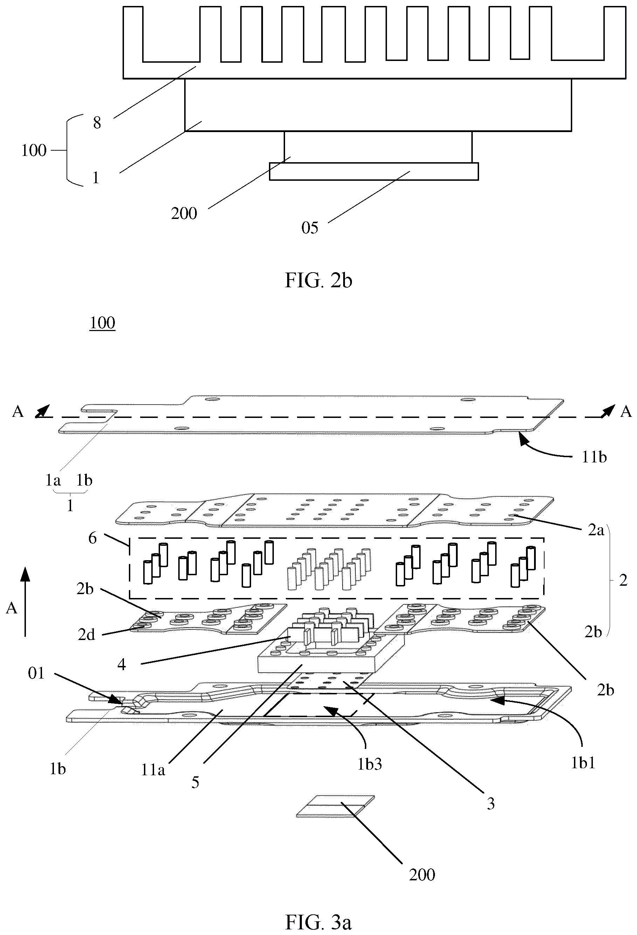

FIG. 2b is a diagram of a structure of a chip package structure according to an embodiment of this application. As shown in FIG. 2b, the chip package structure includes a substrate 05, a chip 200, and a vapor chamber 100. The chip 200 is disposed on the substrate 05, and the vapor chamber 100 is disposed on a side that is of the chip 200 and that is away from the substrate 05.

The vapor chamber 100 is integrated on the chip 200, so that more effective heat dissipation can be achieved for the chip 200. This improves a heat dissipation capability of the chip 200.

The chip package structure shown in FIG. 2b may be disposed in an electronic device as a memory or a central memory. The memory may be an SRAM memory or another memory. A type of the memory is not limited in this application.

FIG. 2b shows an example in which one chip 200 is integrated on the substrate. Certainly, more chips 200 may alternatively be disposed on the substrate.

When a plurality of chips 200 are disposed on the substrate 05, one vapor chamber 100 may be configured for each chip 200, or the plurality of chips 200 may share one vapor chamber 100.

The vapor chamber is an important component for dissipating heat for the heat generating component in the electronic device, and heat dissipation performance of the vapor chamber directly affects performance of the heat generating component. Embodiments of this application provide a vapor chamber, which can reduce resistance to a coolant returning. This facilitates liquid circulation in the vapor chamber. The vapor chamber can transfer more heat per unit of heat dissipation area, so that heat dissipation performance of the vapor chamber is improved.

The following describes in detail the vapor chamber provided in embodiments of this application with reference to the accompanying drawings.

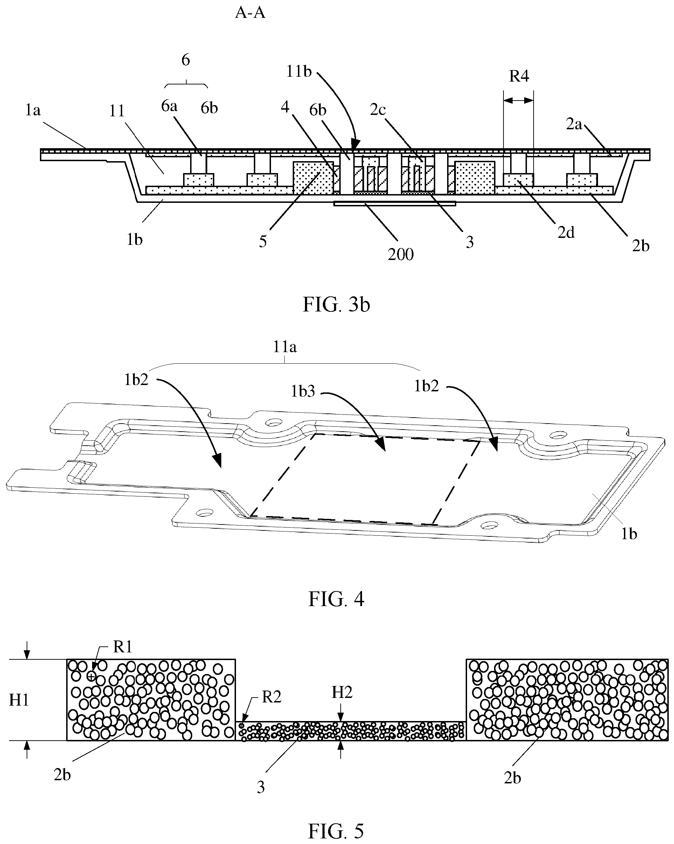

FIG. 3a is a schematic exploded view of a vapor chamber according to an embodiment of this application. FIG. 3b is a schematic cross-sectional view of the assembled vapor chamber shown in FIG. 3a. With reference to both FIG. 3a and FIG. 3b, in some embodiments, a vapor chamber 100 includes a housing 1 and a first capillary structure 2.

The housing 1 is a fully enclosed space. A cavity 11 is formed in the housing 1, and the cavity 11 contains a circulating medium. In a fully enclosed space (namely, the cavity 11) in the housing 1, energy is transferred through vapor-liquid phase change of the circulating medium, to implement temperature equalization and heat dissipation. The circulating medium may be a coolant. There are a plurality of available materials for the coolant. For example, the coolant may be a fluorinated fluid, or may include at least one of water, methanol, alcohol, or acetone. In some embodiments, a liquid injection port 01 is provided on the housing 1, and the circulating medium contained in the cavity 11 may be injected into the cavity 11 through the liquid injection port 01 shown in FIG. 3a. A position at which the liquid injection port 01 is provided is not limited in this application.

It may be understood that the housing 1 has a part close to a heat generating component (for example, a chip 200 shown in FIG. 3a) and a part away from the heat generating component. The part that is of the housing 1 and that is close to the heat generating component receives heat of the heat generating component, and transfers the heat to the part that is of the housing and that is away from the heat generating component, to complete heat transfer in the vapor chamber.

Inside the housing 1, the housing 1 has a first surface 11a and a second surface 11b that enclose the cavity 11, and the first surface 11a is opposite to the second surface 11b. The first surface 11a is a surface close to the heat generating component. In this case, the first surface 11a can be used as a position at which the circulating medium is heated and evaporated, and the second surface 11b can be used as a position at which the heated and evaporated circulating medium is condensed after being cooled.

There are a plurality of implementations of forming the cavity 11. The following describes several implementations as examples.

As shown in FIG. 3a, in an implementation, the housing 1 includes an upper cover 1a and a lower cover 1b, and the upper cover 1a and the lower cover 1b may be brazed together to form a fully enclosed structure. The upper cover 1a may be a straight plate, and the lower cover 1b may be recessed to form an accommodating space 1b1. In this case, after the upper cover 1a and the lower cover 1b are fastened together, the accommodating space 1b1 and the upper cover 1a together enclose the cavity 11. A bottom surface of the accommodating space 1b1 of the lower cover 1b is the first surface 11a, a surface that is of the upper cover 1a and that is close to the lower cover 1b is the second surface 11b, and the first surface 11a is opposite to the second surface 11b. The first surface 11a may be used as a surface in contact with the heat generating component, and the second surface 11b may be used as a position for vapor condensation.

In another implementation, the upper cover 1a may be recessed to form an accommodating space, and the lower cover 1b may be a straight-plate structure. In this case, the cavity 11 can also be formed by fastening the upper cover 1a and the lower cover 1b.

In another implementation, the upper cover 1a and the lower cover 1b each may be recessed to form an accommodating space. In this case, the cavity 11 can also be formed by fastening the upper cover 1a and the lower cover 1b.

The foregoing merely uses the upper cover 1a and the lower cover 1b as an example to describe the implementations of forming the cavity 11. However, in addition to the upper cover 1a and the lower cover 1b, the housing 1 may further include a middle frame disposed between the upper cover 1a and the lower cover 1b. The upper cover 1a is fastened to the middle frame, and the lower cover 1b is fastened to the middle frame. A fastening manner may be vacuum brazing. In this case, the upper cover 1a, the middle frame, and the lower cover 1b together enclose the cavity 11. Certainly, the housing 1 may alternatively be an integrally formed structure, or may be a structure formed by connecting a plurality of components together. This is not limited in this application.

In addition, FIG. 3a and FIG. 3b merely provide an implementation of the housing 1 as an example, and a shape and dimensions of the housing 1 are not limited by FIG. 3a and FIG. 3b. For example, the housing 1 may be in an irregular shape shown in FIG. 3a and FIG. 3b, or may be in a regular shape, for example, in a shape of a rectangle or in a shape of a circle.

For ease of description, a direction A is defined as a direction from a second part 1b3 to the second surface 11b.

The cavity is an enclosed space. Therefore, in a process in which the vapor chamber dissipates heat for the heat generating component, the circulating medium heated and evaporated in the cavity needs to be able to return to the evaporation position in the vapor chamber after being cooled and condensed. In this way, continuous heat dissipation of the vapor chamber can be ensured. Otherwise, when the circulating medium is absent at the evaporation position, the heat of the heat generating component cannot be taken away. To implement circulation of the circulating medium, in embodiments of this application, a capillary structure is formed on surfaces of the housing that enclose the cavity, to implement return of the circulating medium.

The capillary structure may also be referred to as a wick structure or a microstructure. The wick structure may be a metal wire mesh, a microgroove, a fiber filament, or the like, or may be a sintered metal powder wick or a combination of several structures. Compared with the metal wire mesh, the microgroove, and the fiber filament, the sintered metal powder wick has several advantages, for example, low thermal resistance. In addition, because the sintered powder wick usually has a porosity of over 60%, the sintered powder wick has a relatively large evaporation surface area.

As an important structure in the vapor chamber, the capillary structure is crucial to a heat dissipation function of vapor chamber. In embodiments of this application, capillary structures with different capillary forces are disposed on different surfaces that enclose the cavity, to reduce return resistance to the circulating medium returning and therefore improve heat dissipation performance of the vapor chamber. The following describes the capillary structures provided in embodiments of this application with reference to the accompanying drawings.

With reference to both FIG. 3b and FIG. 4, the first capillary structure 2 is disposed on both the first surface 11a and the second surface 11b. The first capillary structure 2 includes a first capillary layer 2a and a second capillary layer 2b. The first capillary layer 2a is disposed on the second surface 11b. The first surface 11a includes a first part 1b2 and the second part 1b3. The second capillary layer 2b is disposed on the first part 1b2. A second capillary structure 3 is disposed on the second part 1b3.

In some embodiments, a capillary force of the first capillary structure 2 is less than a capillary force of the second capillary structure 3. The capillary force of the second capillary structure 3 is large, which increases a driving force for flow of a working fluid. As a result, the vapor chamber has a high heat transfer capacity. The second capillary structure has a relatively large capillary force, which can provide a relatively large driving force for circulation during evaporation and boiling of the circulating medium. The circulating medium on the second part is fully evaporated and takes away as much heat as possible from the heat generating component, and a large amount of vapor is condensed on the second surface. The first capillary layer on the second surface has a relatively small capillary force but a relatively high permeability, so that the first capillary layer can transfer the condensed circulating medium to the first surface. The first part of the first surface has a higher permeability than the second part of the first surface. The first part of the first surface can transfer the circulating medium from the second surface to the second part of the first surface.

In some other embodiments, in a direction perpendicular to the first surface 11a, a thickness H1 of the second capillary layer 2b is greater than a thickness H2 of the second capillary structure 3.

When the thickness H 1 of the second capillary layer 2b is sufficiently greater than the thickness H2 of the second capillary structure 3, the returning circulating medium can still obtain a relatively large driving force even if a capillary pore size R1 of the second capillary layer 2b is less than or equal to a capillary pore size R2 of the second capillary structure 3. Thinning of the second capillary structure 3 reduces a temperature difference. In this case, the second part is used as an evaporator of the vapor chamber, and the first part is used as a return region of the vapor chamber. Return resistance to the circulating medium returning from the first part to the second part is relatively small, and the vapor chamber has a high heat transfer capacity. This ensures return of the circulating medium, thereby improving the heat dissipation performance of the vapor chamber.

For the purpose of further reducing the return resistance to the circulating medium returning from the first part to the second part, as shown in FIG. 5, in some embodiments, in the direction perpendicular to the first surface 11a, the thickness H1 of the second capillary layer 2b is greater than the thickness H2 of the second capillary structure 3, and the capillary pore size R1 of the second capillary layer 2b is greater than the capillary pore size R2 of the second capillary structure 3. A capillary pore in the second capillary layer 2b and a capillary pore in the second capillary structure 3 each are a communicating pore. FIG. 5 merely shows an example of porous structures of the second capillary layer 2b and the second capillary structure 3, and does not constitute a limitation on the porous structures of the second capillary layer 2b and the second capillary structure 3.

It may be understood that FIG. 5 merely shows an example of a relationship between the thicknesses of the second capillary layer 2b and the second capillary structure 3 and a relationship between the capillary pore sizes of the second capillary layer 2b and the second capillary structure 3, and does not constitute a limitation on actual thicknesses of the second capillary layer 2b and the second capillary structure 3. Values of the actual thicknesses and actual capillary pore sizes of the second capillary layer 2b and the second capillary structure 3 may be determined based on actual heat source (heat source) power consumption distribution of the heat generating component.

Compared with the first capillary structure with the larger capillary pore size, the second capillary structure with the smaller capillary pore size has a larger capillary force, features a larger contact area between particles, and has a higher thermal conductivity. This facilitates return of the circulating medium. The thickness of the second capillary structure on the second part is smaller, so that a temperature difference for heat transfer on a surface of the second capillary structure can be reduced during boiling of the circulating medium, and thermal resistance can be reduced. As a result, liquid supply is maintained at a high heat flux, so that the second part has better evaporation performance. The thickness of the first capillary structure on the first part is larger, and due to the larger capillary thickness, a larger cross-sectional area can be provided for liquid replenishment, to prevent liquid from being dried out. As a result, the first part has a better capability of transferring the circulating medium.

In a process in which the circulating medium flows back into the second part from a periphery of the second part, the circulating medium is evaporated. As a position is closer to the center of the second part, the circulating medium is less likely to be reallocated to the position. This does not facilitate evaporation and circulation of the circulating medium in the vapor chamber. To resolve this problem, a plurality of capillary rib plates are disposed on the second part in the vapor chamber provided in embodiments of this application, so that circulating medium allocation throughout the second part is implemented. The following describes a structure of the capillary rib plate with reference to the accompanying drawings.

Still with reference to FIG. 3b and FIG. 4, at least one capillary rib plate 4 is disposed on the second part 1b3. The capillary rib plate 4 is configured to reallocate, to the second capillary structure 3 on the second part 1b3, the circulating medium above the second part 1b3 and the circulating medium returning from the second capillary layer 2b on the first part 1b2.

In some embodiments, a capillary pore size of the capillary rib plate 4 is greater than the capillary pore size of the second capillary structure 3. In this case, the capillary rib plate 4 has a higher permeability, and when the capillary rib plate 4 transfers the circulating medium to the second capillary structure 3, return resistance is relatively small.

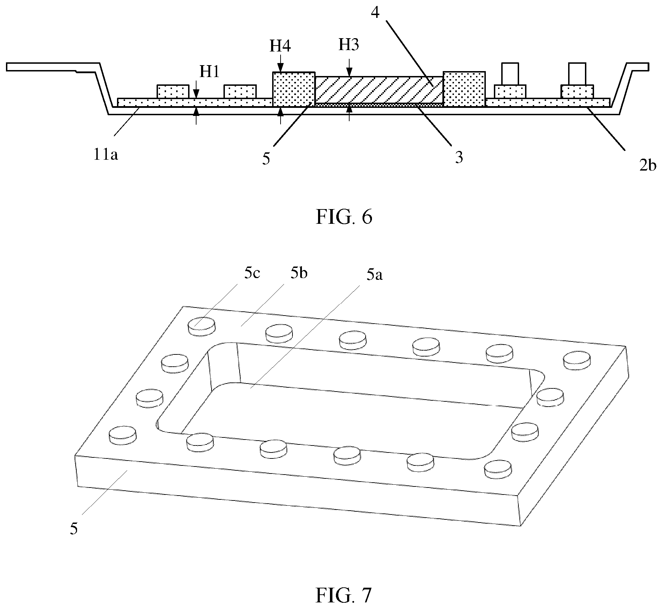

As shown in FIG. 6, in some embodiments, in the direction perpendicular to the first surface 11a, a thickness H3 of the capillary rib plate 4 is greater than or equal to the thickness H1 of the second capillary layer 2b.

Heat source power distribution or thermal load changes with time. Therefore, a temperature may vary throughout the first surface, and a returning coolant may be dried out at a position with a relatively high temperature on the first surface. To ensure that the circulating medium can return to the capillary rib plate and the capillary rib plate can transfer the returning circulating medium to each region of the second part, a problem of local dry -out needs to be resolved.

Still with reference to FIG. 3b and FIG. 4, in some embodiments, a third capillary structure 5 is disposed on a periphery of the second part 1b3, and the third capillary structure 5 extends from the second part 1b3 toward the second surface 11b (as shown in FIG. 3a). As shown in FIG. 6, in an extension direction of the third capillary structure 5 (or in the direction perpendicular to the first surface 11a), a thickness H4 of the third capillary structure 5 is greater than the thickness H1 of the second capillary layer 2b disposed on the first part 1b2.

In an implementation, a capillary pore size of the third capillary structure 5 is greater than the capillary pore size of the second capillary structure 3. A capillary force of the third capillary structure 5 is less than the capillary force of the second capillary structure 3, but a permeability of the third capillary structure 5 is greater than a permeability of the second capillary structure 3. This helps the returning circulating medium flow into the third capillary structure 5, so that the third capillary structure 5 can function as a buffer, and the third capillary structure 5 transfers more circulating media to the capillary rib plate 4.

There may be a connection relationship between the third capillary structure 5 and the second capillary layer 2b as shown in FIG. 6. In an implementation, the third capillary structure 5 and the second capillary layer 2b may be an integrated structure. In another implementation, the third capillary structure 5 and the second capillary layer 2b may be separate structures.

As shown in FIG. 6, in some embodiments, the thickness H4 of the third capillary structure 5 is greater than the thickness H3 of the capillary rib plate 4.

The following provides a feasible implementation of the third capillary structure.

FIG. 7 is a diagram of a structure of the capillary structure of the vapor chamber shown in FIG. 3b. As shown in FIG. 7, a through hole 5a is formed in the third capillary structure 5, and the at least one capillary rib plate 4 and the second capillary structure 3 may be disposed in the through hole 5a. The third capillary structure 5 may be in a cubic shape shown in FIG. 7, or may be a circle or a polygon. A shape of the third capillary structure 5 is not limited in this application. It may be understood that the shape of the third capillary structure 5 may alternatively be set flexibly based on the shape of the housing. Refer to the following embodiment in which the housing is provided with a concave cavity. Details are not described herein.

In some embodiments, as shown in FIG. 7, the third capillary structure 5 has a third surface 5b away from the second part 1b3; and a plurality of buffer posts 5c are disposed on the third surface 5b at intervals, and the buffer post 5c extends toward the second surface 11b. The buffer post 5c is a capillary structure with a capillary pore size greater than the capillary pore size of the second capillary structure 3. As a result, a channel for the circulating medium to return is increased. In an implementation, the buffer post 5c is in contact with the first capillary layer 2a on the second surface 11b, and transfers the condensed circulating medium on the first capillary layer 2a to the second capillary structure 3.

In an implementation, the third surface 5b may be parallel to the first surface 11a (refer to FIG. 3b).

In the foregoing, the third capillary structure is disposed around the capillary rib plate, so that local dry-out during return of the circulating medium can be reduced.

While an area of an effective region for evaporation is ensured, more capillary rib plates may be disposed, to optimize the heat dissipation performance of the vapor chamber. The following describes several feasible implementations of the capillary rib plate with reference to the accompanying drawings.

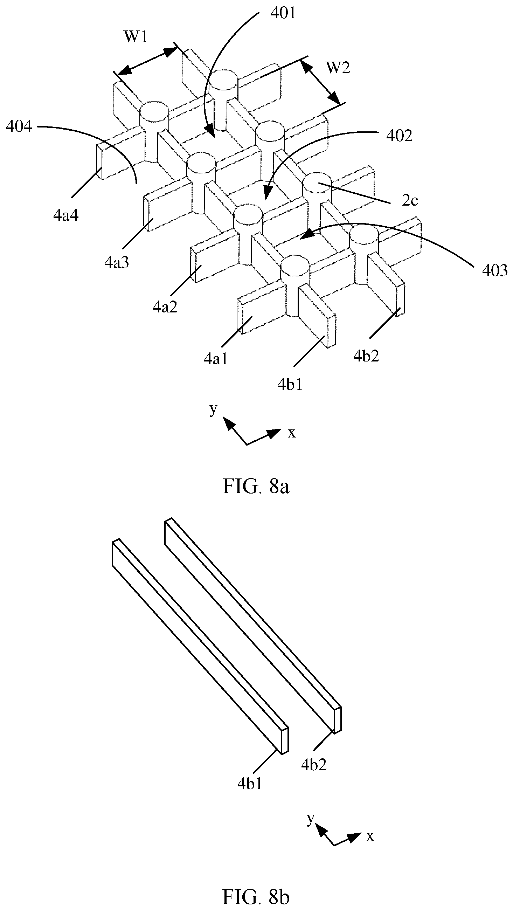

FIG. 8a is a diagram of a structure of an implementation of a plurality of capillary rib plates of the vapor chamber shown in FIG. 3b. As shown in FIG. 8a, a plurality of capillary rib plates 4 are disposed on the second part 1b3 at intervals, to form, in space in the cavity 11, a plurality of channels for the circulating medium to flow through. Alternatively, the capillary rib plate 4 can be used as a channel for the circulating medium to flow through. The second capillary layer 2b on the first part 1b2 transfers the circulating medium to the plurality of capillary rib plate 4 with a minimum liquid pressure loss, and the plurality of capillary rib plates 4 reallocate the obtained circulating medium to the second capillary structure 3 on the second part 1b3. The plurality of capillary rib plates 4 are disposed, so that a heat dissipation loss of the circulating medium can be reduced.

For ease of description, a long-edge direction of the vapor chamber is defined as an x direction, and a short-edge direction of the vapor chamber is defined as a y direction.

As shown in FIG. 8a, in an implementation, the plurality of capillary rib plates 4 are arranged in an array in two mutually perpendicular directions (the x direction and the y direction), to form, on the second part 1b3, a plurality of grid structures for the circulating medium to flow through. For example, the plurality of capillary rib plates 4 may include a first horizontal plate 4a1, a second horizontal plate 4a2, a third horizontal plate 4a3, and a fourth horizontal plate 4a4 that extend in the x direction, and a first vertical plate 4b1 and a first vertical plate 4b2 that extend in the y direction. The first horizontal plate 4a1, the second horizontal plate 4a2, the third horizontal plate 4a3, and the fourth horizontal plate 4a4 are arranged in an array in the y direction, and a spacing between two adjacent horizontal plates is W2. The first vertical plates 4b1 and the first vertical plates 4b2 are arranged in an array in the x direction, and a spacing between the vertical plates is W1. The third horizontal plate 4a3 is connected to all of the first horizontal plate 4a1, the second horizontal plate 4a2, the third horizontal plate 4a3, and the fourth horizontal plate 4a4, and the fourth horizontal plate 4a4 is connected to all of the first horizontal plate 4a1, the second horizontal plate 4a2, the third horizontal plate 4a3, and the fourth horizontal plate 4a4. As a result, the circulating medium can be evenly allocated to the second capillary structure 3 on the second part 1b3.

In addition, the plurality of capillary rib plates 4 enclose a vapor region for the vapor to pass through, to ensure that the circulating medium on the second part 1b3 is normally evaporated. For example, the third horizontal plate 4a3, the fourth horizontal plate 4a4, the first vertical plate 4b1, and the first vertical plate 4b2 together enclose a first vapor region 401; the second horizontal plate 4a2, the third horizontal plate 4a3, the first vertical plate 4b1, and the first vertical plate 4b2 together enclose a second vapor region 402; the first horizontal plate 4a1, the second horizontal plate 4a2, the first vertical plate 4b1, and the first vertical plate 4b2 together enclose a third vapor region 403; the third horizontal plate 4a3, the fourth horizontal plate 4a4, and the first vertical plate 4b1 together enclose a fourth vapor region 404; and so on.

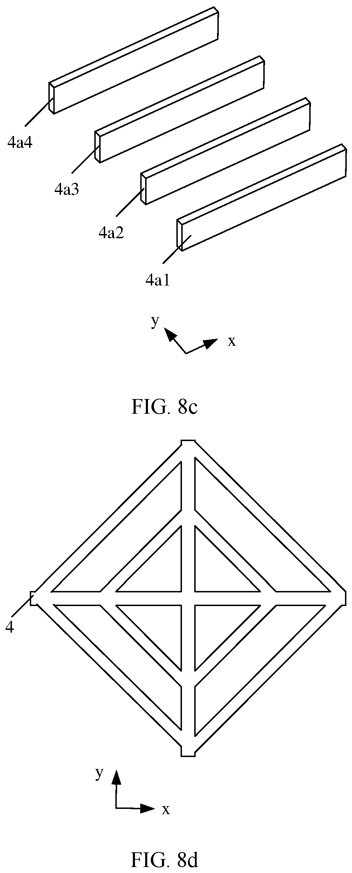

In an implementation, the plurality of capillary rib plates 4 may be disposed at intervals in only one direction. For example, as shown in FIG. 8b, the capillary rib plates 4 are disposed at intervals in the x direction. For another example, as shown in FIG. 8c, the capillary rib plates 4 are disposed at intervals in the y direction.

In another implementation, the plurality of capillary rib plates 4 may alternatively be disposed at intervals in a plurality of directions, as shown in FIG. 8d. Included angles between the plurality of directions are not limited in this application.

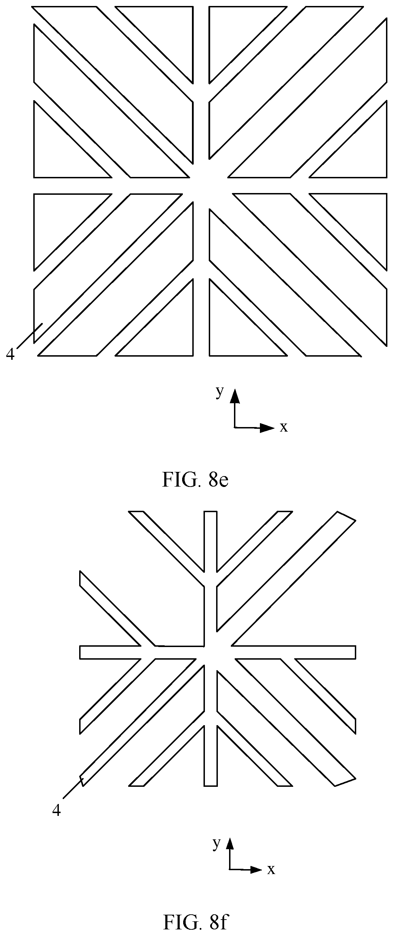

In addition, in some embodiments, a structure formed by the plurality of capillary rib plates 4 may be a symmetric structure shown in FIG. 8a. In some other implementations, a structure formed by the plurality of capillary rib plates 4 may alternatively be an asymmetric structure shown in FIG. 8e or FIG. 8f.

Besides, the plurality of capillary rib plates 4 may be in a same shape and have a same thickness as shown in FIG. 8a, or may be in different shapes and have different thicknesses as shown in FIG. 8e or FIG. 8f.

The capillary rib plate 4 has a plurality of available shapes, and may be a cubic structure or a curved structure, for example, an enclosed structure whose periphery is an arc, a circular arc, a semi-circular arc, or the like. A shape of the capillary rib plate 4 is not limited in this application.

To ensure cooling performance of the vapor chamber, the area of the effective region for evaporation on the second capillary structure 3 needs to be ensured.

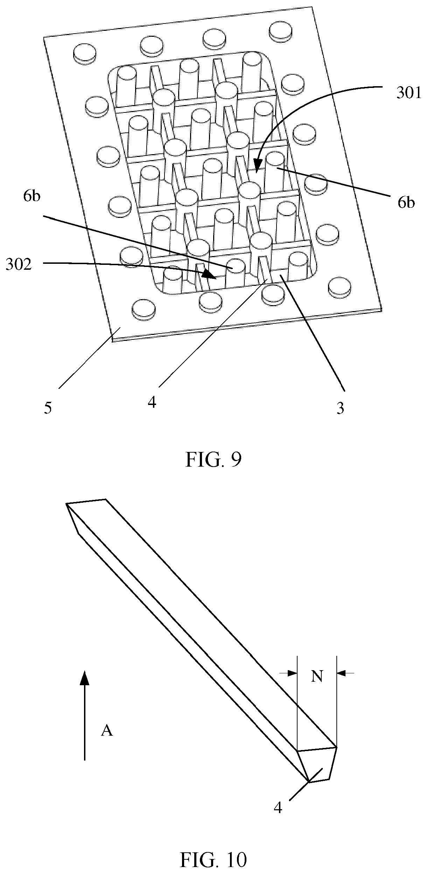

FIG. 9 is a diagram of a structure of the capillary structure of the vapor chamber shown in FIG. 3b. As shown in FIG. 9, a plurality of capillary rib plates 4 are disposed on the second capillary structure 3, and the plurality of capillary rib plates 4 and the second capillary structure 3 are located in the third capillary structure 5. The second capillary structure 3 has a part on which no capillary rib plate 4 is disposed (for example, a first sub-region 301 or a second sub-region 302 shown in FIG. 9). The part on which no capillary rib plate 4 is disposed is exposed, and can be used as an effective region for evaporation of the circulating medium, to ensure that the circulating medium is normally evaporated after being heated.

As shown in FIG. 10, a thickness N of the capillary rib plate 4 gradually increases from the second part 1b3 to the second surface 11 (in the direction A shown in FIG. 3a). The capillary rib plate 4 having a larger dimension at an upper end and a smaller dimension at a lower end can maximally ensure the area of the effective region for evaporation on the second capillary structure 3. This contributes to a cooling function of the vapor chamber.

The foregoing merely provides several feasible implementations of the plurality of capillary rib plates as examples, and does not constitute a limitation on a structure and a disposing manner of the plurality of capillary rib plates.

To increase the channel for the circulating medium to return, with reference to both FIG. 3b and FIG. 4, in some embodiments, a plurality of first capillary posts 2c are further disposed on the second part 1b3 at intervals, and the first capillary post 2c is connected to the first capillary layer 2a on the second surface 11b.

As shown in FIG. 8a, in an implementation, the first capillary post 2c is located at a joint of the plurality of capillary rib plates 4. The first capillary post 2c is disposed in this way, so that space occupied by the joint of the plurality of capillary rib plates 4 is effectively used. As a result, the area of the effective region for evaporation on the second capillary structure 3 is maximally ensured while the channel for the circulating medium to return is increased.

In an implementation, the first capillary post 2c may be in a shape of a cylinder shown in FIG. 3b.

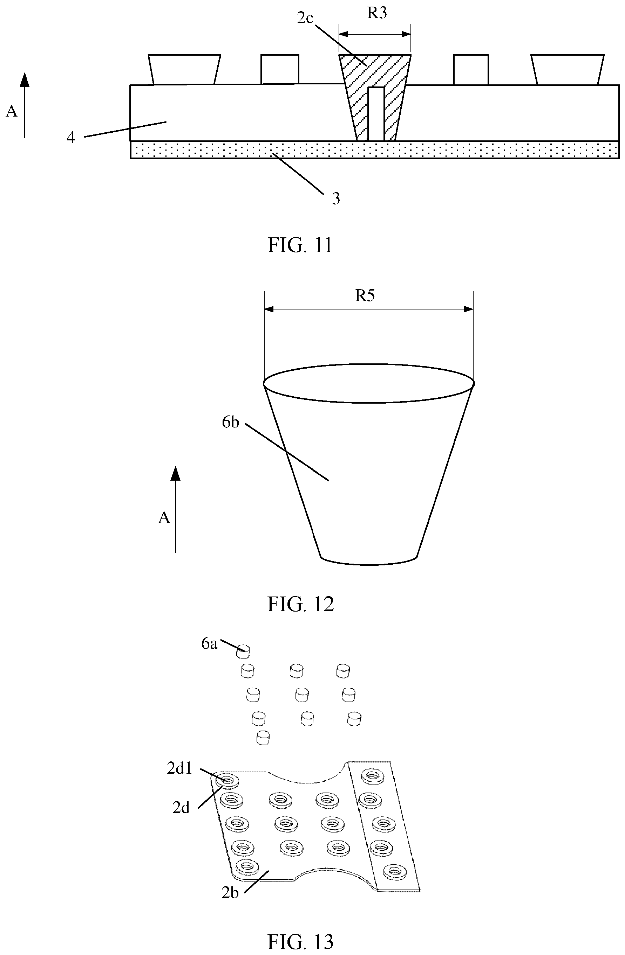

As shown in FIG. 11, in another implementation, a radial dimension R3 of the first capillary post 2c gradually increases from the second part 1b3 to the second surface 11 (in the direction A shown in FIG. 3a).

For the purpose of further increasing the high permeability of the first capillary structure to transfer the circulating medium to the second part with a relatively small pressure loss, in some embodiments, a capillary pore size of the first capillary post 2c is greater than the capillary pore size R2 of the second capillary structure 3.

To increase the channel for the circulating medium to return, with reference to both FIG. 3b and FIG. 4, in some embodiments, a second capillary post 2d is disposed on the first capillary structure 2. The radial dimension R3 of the first capillary post 2c is less than a radial dimension R4 of the second capillary post 2d.

As shown in FIG. 3b, in an implementation, a plurality of second capillary posts 2d are disposed on the second capillary layer 2b.

In another implementation, a plurality of second capillary posts 2d may be disposed on the second capillary layer 2b, and a plurality of second capillary posts 2d may also be disposed on the first capillary layer 2a. Alternatively, in still another implementation, a plurality of second capillary posts 2d may be disposed on only the first capillary layer 2a. The second capillary post 2d is disposed, to connect the first capillary layer 2a on the second surface 11b to the second capillary layer 2b on the first surface 11a and therefore implement return of the circulating medium.

For the purpose of further increasing the high permeability of the first capillary structure to transfer the circulating medium to the second part with a relatively small pressure loss, in some embodiments, a capillary pore size of the second capillary post 2d is greater than the capillary pore size R2 of the second capillary structure 3.

To prevent the housing from locally collapsing, a support pillar is disposed in the vapor chamber provided in embodiments of this application.

Still with reference to FIG. 3b and FIG. 4, in some embodiments, a plurality of first support pillars 6b are further disposed on the second part 1b3 at intervals, and the first support pillar 6b extends from the second part 1b3 to the second surface 11b. As shown in FIG. 9, in an implementation, the first support pillar 6b is located in the grid structure. For example, as shown in FIG. 9, the first support pillar 6b may be disposed in the first sub-region 301, and the first support pillar 6b may also be disposed in the second sub-region 302.

In an implementation, the plurality of first support pillars 6b are evenly arranged on the second part 1b3. Each first support pillar 6b is subject to a uniform force, supporting the housing and preventing the housing from locally collapsing.

To maximally ensure the area of the effective region for evaporation on the second capillary structure, in the direction A (as shown in FIG. 3, the direction A is the direction from the second part 1b3 to the second surface 11b), the first support pillar 6b having a larger dimension at an upper end and a smaller dimension at a lower end can maximally ensure the area of the effective region for evaporation on the second capillary structure, thereby ensuring an area of an evaporation and/or boiling region. This contributes to the cooling function of the vapor chamber.

As shown in FIG. 12, in an implementation, a radial dimension R5 of the first support pillar 6b gradually increases from the second part 1b3 to the second surface 11 (in the direction A shown in FIG. 3a).

The first support pillar 6b may be in a shape of a cone shown in FIG. 12, or may be in a shape of a frustum with a square cross section. A shape of the first support pillar 6b is not limited in this application.

In addition to the first support pillar 6b disposed between the second part 1b3 and the upper cover 1a, still with reference to FIG. 3b and FIG. 4, in some embodiments, a second support pillar 6a is disposed between the first part 1b2 and the upper cover 1a, and the second support pillar 6a supports the first part 1b2 and the upper cover 1a. In an implementation, a plurality of second support pillars 6a are disposed on the first part 1b2 at intervals, and the second support pillar 6a extends from the first part 1b2 to the second surface 11b.

When both the plurality of second capillary posts 2d and the plurality of second support pillars 6a are disposed on the first part 1b2, to save space and ensure surface areas of capillary structures (the second capillary post 2d and the second capillary layer 2b), as shown in FIG. 13, in some embodiments, a capillary pore 2d1 for accommodating the second support pillar 6a is provided in the second capillary post 2d. The second support pillar 6a passes through the capillary pore 2d1, with one end in contact with the first part 1b2 and the other end in contact with the second surface 11b, thereby supporting the first part 1b2 and the upper cover 1a.

In some cases, when the vapor chamber is working, especially when the vapor chamber is disposed perpendicular to the ground, uneven heat distribution results in a local hot spot in the vapor chamber. A temperature of the hot spot is excessively high, which does not facilitate recirculation of the circulating medium. In this application, a groove is provided in the vapor chamber, and the circulating medium is provided in the groove. When vapor is generated due to an excessively high temperature, the vapor pushes the circulating medium in the groove to return to the second part. This liquid recirculation helps avoid the hot spot. The following describes in detail the groove provided in the vapor chamber with reference to the accompanying drawings.

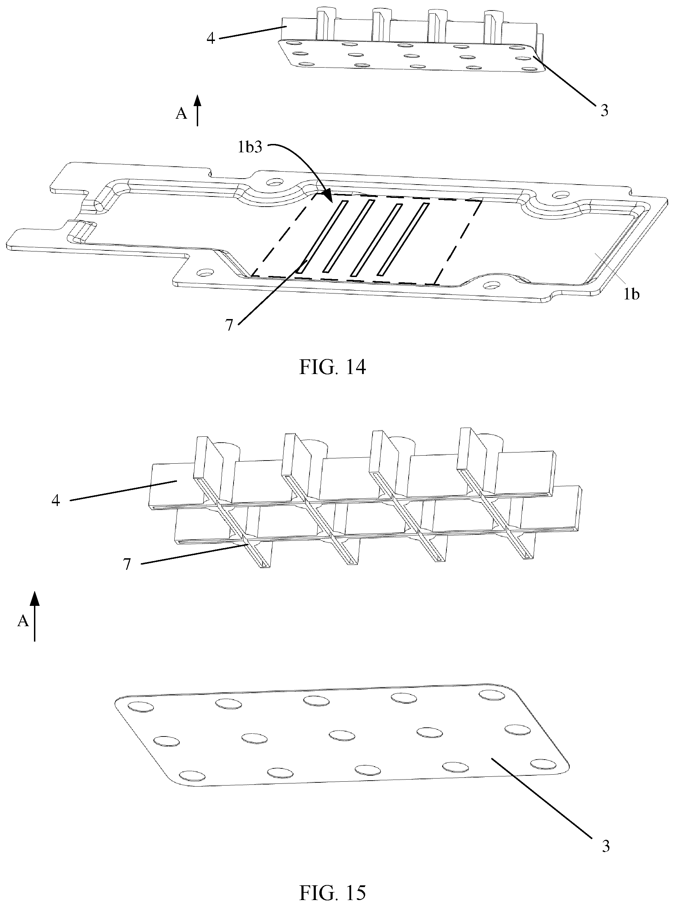

FIG. 14 is a diagram of a structure of an embodiment of grooves of a vapor chamber according to an embodiment of this application. As shown in FIG. 14, in some embodiments, at least one groove 7 is provided on the second part 1b3, and the at least one groove 7 is configured to contain the coolant. In this embodiment, during forming of the groove 7, the groove 7 may be first provided on the second part 1b3. Then, the coolant is provided in the groove 7. Finally, the second capillary structure 3 is formed on the second part 1b3.

FIG. 15 is a diagram of a structure of another embodiment of grooves of a vapor chamber according to an embodiment of this application. As shown in FIG. 15, in some embodiments, at least one groove 7 is provided on a surface that is of the capillary rib plate 4 and that is close to the second capillary structure 3, and the at least one groove 7 is configured to contain the circulating medium. In this embodiment, during forming of the groove 7, the capillary rib plate 4 and the second capillary structure 3 may be separately formed, and when the capillary rib plate 4 is formed, the groove 7 is formed on a bottom surface of the capillary rib plate 4. Then, the capillary rib plate 4 with the groove 7 is disposed on the second capillary structure 3.

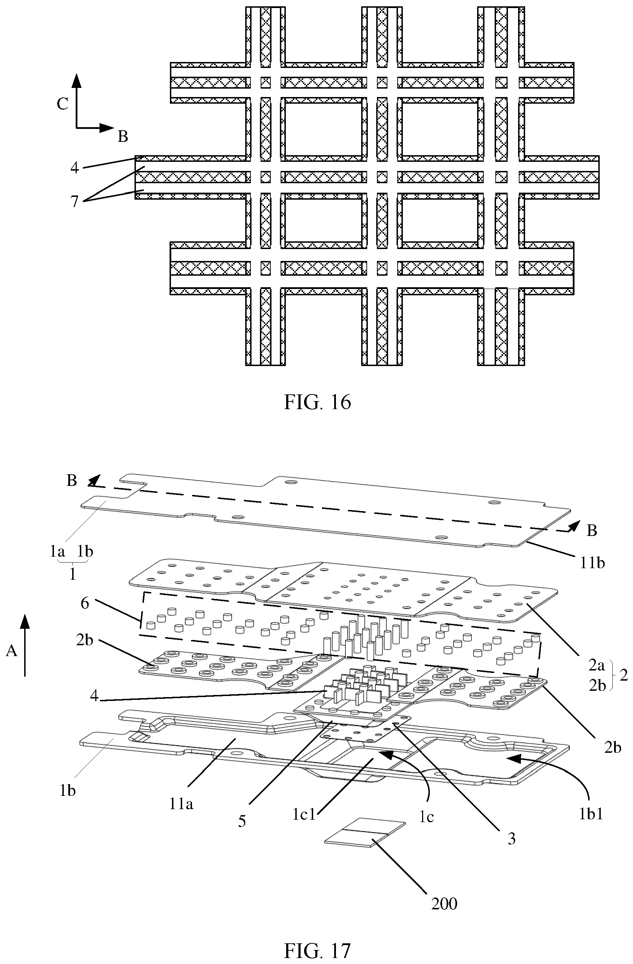

As shown in FIG. 16, in some embodiments, a plurality of grooves 7 are provided, the groove 7 extends in a long-edge direction B of the capillary rib plate 4, and the plurality of grooves 7 are provided side by side in a short-edge direction C of the capillary rib plate 4.

It may be understood that, properly increasing a quantity of provided grooves 7 helps avoid the hot spot.

For the purpose of reducing a size of the vapor chamber while maintaining high heat dissipation efficiency, the housing of the vapor chamber may be in an irregular shape shown in FIG. 17. In this case, the cavity is no longer a cubic structure in the foregoing embodiments. To adapt to the change in structure, differentiated designs are applied to the components disposed in the cavity. The following provides a description with reference to the accompanying drawings.

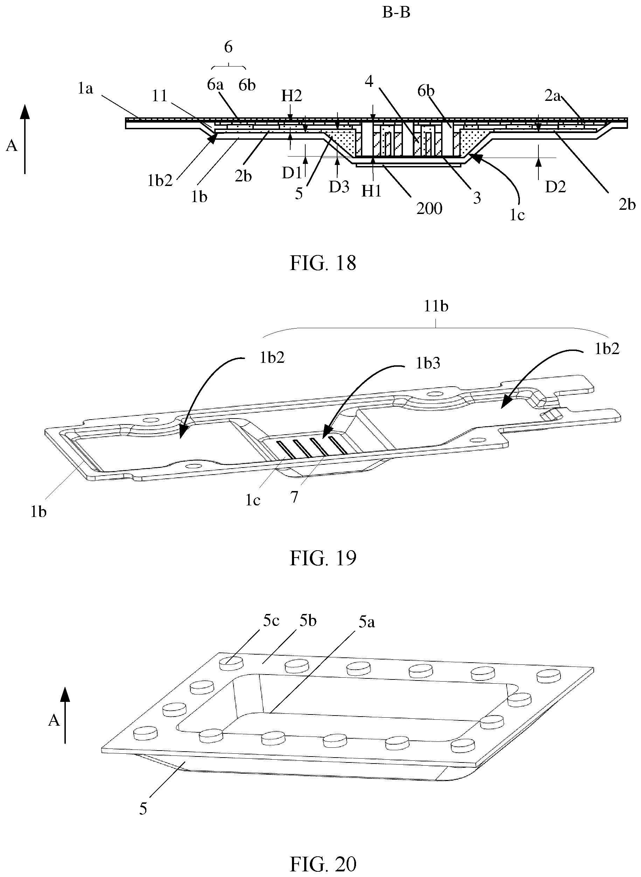

FIG. 17 is a diagram of a structure of a vapor chamber according to an embodiment of this application. FIG. 18 is a diagram of a structure of the assembled vapor chamber shown in FIG. 17. With reference to both FIG. 17 and FIG. 18, in some embodiments, a concave cavity 1c is provided on a lower cover 1b. A bottom surface 1c1 of the concave cavity 1c is close to a heat generating component (for example, a chip 200 shown in FIG. 17). In this case, the concave cavity 1c is used as an evaporator, and a circulating medium in the concave cavity 1c is heated and evaporated. Dimensions and a position of the concave cavity 1c are affected by heat source power consumption distribution of the heat generating component.

In addition, the concave cavity 1c has a plurality of available shapes. In some embodiments, the concave cavity 1c may be a tapered concave cavity whose cross section perpendicular to a direction A gradually increases and that is shown in FIG. 17, or may be a straight cylinder-shaped concave cavity whose cross section perpendicular to a direction A is unchanged in dimensions. The cross section that is of the concave cavity 1c and that is perpendicular to the direction A may be in a shape of a square shown in FIG. 17 or in a shape of a circle. This is not limited in this application.

FIG. 19 is a diagram of a structure of the lower cover of the vapor chamber shown in FIG. 17. With reference to both FIG. 18 and FIG. 19, the lower cover 1b has a first surface 11a, and the first surface 11a is a surface having a concave wall surface. The concave wall surface includes a bottom surface 1c1 of the concave cavity 1c and a side wall surface 1c2 of the concave cavity 1c. The first surface 11a and a second surface 11b of an upper cover 1a enclose a cavity 11 with the concave cavity 1c.

The first surface 11a includes a first part 1b2 and the second part 1b3. The first part 1b2 includes other positions on the first surface 11a excluding the concave wall surface. The second part 1b3 includes the bottom surface 1c1 of the concave cavity 1c.

A first capillary layer 2a is disposed on the second surface 11b. A second capillary layer 2b is disposed on the first part 1b2. A second capillary structure 3 is disposed on the bottom surface 1c1 of the concave cavity 1c. For disposing manners, thicknesses, capillary pore sizes, and the like of the first capillary layer 2a, the second capillary layer 2b, the second capillary structure 3, refer to the foregoing embodiments. Details are not described herein again.

A plurality of capillary rib plates 4 are further disposed on the bottom surface 1c1 of the concave cavity 1c. For a disposing manner, a thickness, a capillary pore size, and the like of the capillary rib plate 4, refer to the foregoing embodiments. Details are not described herein again.

As shown in FIG. 18, in some embodiments, a thickness D1 of the capillary rib plate 4 in the direction A is less than a thickness D2 of the concave cavity 1c in the direction A. In an implementation, the capillary rib plate 4 may be flush with the first part 1b2.

It may be understood that FIG. 18 merely provides a feasible implementation of the capillary rib plate as an example, and does not constitute a limitation on the thickness D1 of the capillary rib plate in the direction A. When space in the cavity is sufficient, the thickness D1 of the capillary rib plate 4 in the direction A may be greater than or equal to the thickness D2 of the concave cavity 1c in the direction A.

A third capillary structure 5 is formed on a periphery of the bottom surface 1c1 of the concave cavity 1c. For a thickness, a capillary pore size, and the like of the third capillary structure 5, refer to the foregoing embodiments. Details are not described herein again.

The following describes a disposing manner of the third capillary structure 5 with reference to the accompanying drawings.

To make full use of the space in the cavity 11, as shown in FIG. 18, in some embodiments, a third capillary structure 5 is formed on a side wall of the concave cavity 1c.

In an implementation, as shown in FIG. 18, a thickness D3 of the third capillary structure 5 in the direction A is greater than the thickness D2 of the concave cavity 1c in the direction A. In this case, the third capillary structure 5 extends out of the concave cavity 1c and can be in contact with the second capillary layer 2b on the first part 1b2, and the third capillary structure 5 can receive a circulating medium returned by the second capillary layer 2b.

In an implementation, as shown in FIG. 18, the thickness D3 of the third capillary structure 5 in the direction A is greater than the thickness D1 of the capillary rib plate 4 in the direction A.

In an implementation, with reference to both FIG. 18 and FIG. 20, dimensions of a cross section that is of the third capillary structure 5 and that is perpendicular to the direction A gradually increase. For example, as shown in FIG. 20, the third capillary structure 5 is a frustum structure.

For a buffer post 5c disposed on the third capillary structure 5 and a through hole 5a provided in the third capillary structure 5, refer to the foregoing embodiments. Details are not described herein again.

With reference to FIG. 17 and FIG. 18, a plurality of first support pillars 6b are further disposed on the bottom surface 1c1 of the concave cavity 1c at intervals. A second support pillar 6a is disposed between the first part 1b2 and the upper cover 1a. A height H1 of the first support pillar 6b in the direction A is greater than a height H2 of the second support pillar 6a in the direction A.

To avoid a hot spot, as shown in FIG. 19, at least one groove 7 is provided on the bottom surface 1c1 of the concave cavity 1c, and the at least one groove 7 is configured to contain the circulating medium.

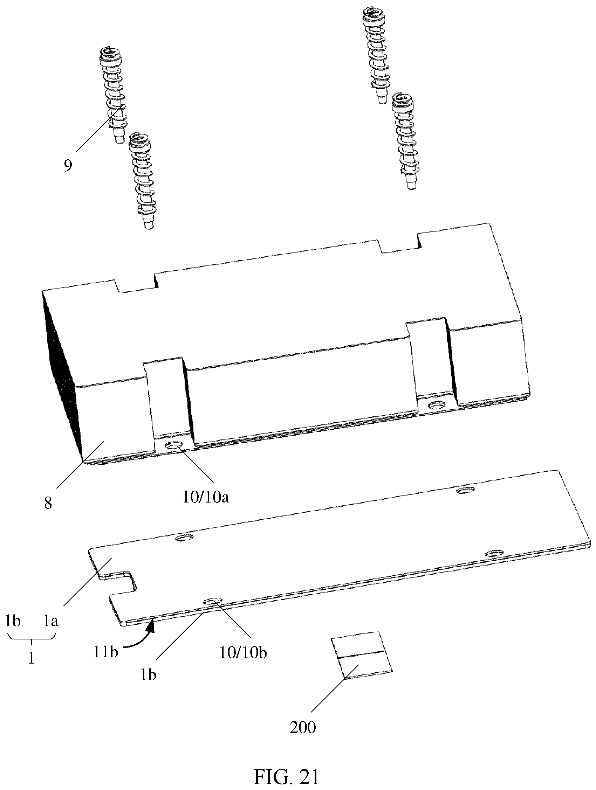

To transfer heat of the housing of the vapor chamber out as soon as possible, as shown in FIG. 21, in some embodiments, the vapor chamber further includes a heat sink 8; and the heat sink 8 is disposed on a side that is of the housing 1 and that is close to the second surface 11b. The heat sink 8 has a plurality of available structure forms, for example, may be an air-cooled fin, or another air-cooled heat sink (a fan), or a liquid-cooled plate.

The heat sink 8 is fastened to the housing 1. There are a plurality of fastening manners, for example, soldering. Alternatively, as shown in FIG. 21, a first installation hole 10a is provided on the heat sink 8, a second installation hole 10b is provided on the housing 1, and a fastener 9 successively passes through the first installation hole 10a and the second installation hole 10b, to fasten the heat sink 8 to the housing 1. In an implementation, the first installation hole 10a on the heat sink 8 may be a through hole, the second installation hole 10b on the housing 1 may be a threaded hole, and the fastener 9 may be a screw.

In some embodiments, a thermal conductive layer is disposed between the heat sink 8 and the housing 1. There are a plurality of materials available for the thermally conductive layer, for example, thermal grease.

Finally, it should be noted that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. A vapor chamber, comprising:
a housing, wherein a cavity is formed in the housing, and the cavity contains a coolant;
the housing has a first surface and a second surface that enclose the cavity, and the first surface is opposite to the second surface;
the first surface comprises a first part and a second part, a first capillary structure is disposed on the first part, and a second capillary structure is disposed on the second part, wherein
a capillary force of the first capillary structure is less than a capillary force of the second capillary structure, or in a direction perpendicular to the first surface, a thickness of the first capillary structure is greater than a thickness of the second capillary structure; and
the first capillary structure is disposed on the second surface.

2. The vapor chamber according to claim 1, wherein a capillary pore size of the first capillary structure is greater than a capillary pore size of the second capillary structure.

3. The vapor chamber according to claim 1 or 2, wherein at least one capillary rib plate is further disposed on the second part.

4. The vapor chamber according to any one of claims 1 to 3, wherein a plurality of capillary rib plates are disposed; and
the plurality of capillary rib plates are arranged in an array in two mutually perpendicular directions, to form a plurality of grid structures through partitioning on the second part.

5. The vapor chamber according to any one of claims 1 to 4, wherein a third capillary structure is disposed on a periphery of the second part, and the third capillary structure extends from the second part toward the second surface; and
in an extending direction of the third capillary structure, a thickness of the third capillary structure is greater than the thickness of the first capillary structure disposed on the first part.

6. The vapor chamber according to claim 5, wherein
the third capillary structure has a third surface away from the second part; and
a plurality of buffer posts are disposed on the third surface at intervals, and the buffer post extends toward the second surface.

7. The vapor chamber according to claim 4, wherein a plurality of first capillary posts are further disposed on the second part at intervals;
the first capillary post is connected to the first capillary structure on the second surface; and
the first capillary post is located at a joint of the plurality of capillary rib plates.

8. The vapor chamber according to claim 7, wherein a radial dimension of the first capillary post gradually increases from the second part to the second surface.

9. The vapor chamber according to claim 7 or 8, wherein a plurality of second capillary posts are disposed on the first part.

10. The vapor chamber according to claim 9, wherein the second capillary post is connected to the first capillary structure on the second surface.

11. The vapor chamber according to claim 4, wherein a plurality of first support pillars are further disposed on the second part at intervals; and
the first support pillar extends from the second part to the second surface.

12. The vapor chamber according to claim 11, wherein a radial dimension of the first support pillar gradually increases from the second part to the second surface.

13. The vapor chamber according to claim 11 or 12, wherein a plurality of second support pillars are disposed on the first part at intervals; and
the second support pillar extends from the first part to the second surface.

14. The vapor chamber according to any one of claims 1 to 6, wherein a plurality of second capillary posts are disposed on the first part at intervals, and a plurality of second support pillars are disposed on the first part at intervals; and
a through hole for accommodating the second support pillar is provided in the second capillary post.

15. The vapor chamber according to any one of claims 1 to 14, wherein at least one groove is provided on the second part, and the at least one groove is configured to contain the coolant.

16. The vapor chamber according to any one of claims 1 to 15, wherein at least one groove is provided on a surface that is of the capillary rib plate and that is close to the second part, and the at least one groove is configured to contain the coolant.

17. The vapor chamber according to claim 16, wherein a plurality of grooves are provided;
the groove extends in a long-edge direction of the capillary rib plate; and
the plurality of grooves are provided side by side in a short-edge direction of the capillary rib plate.

18. The vapor chamber according to any one of claims 1 to 17, wherein a thickness of the capillary rib plate gradually increases from the second part to the second surface.

19. The vapor chamber according to any one of claims 1 to 18, wherein a concave cavity is provided on the first surface, and the second part comprises a bottom surface of the concave cavity.

20. The vapor chamber according to any one of claims 1 to 19, wherein the vapor chamber further comprises a heat sink; and
the heat sink is disposed on a side that is of the housing and that is close to the second surface.

21. The vapor chamber according to claim 20, wherein a thermal conductive layer is disposed between the heat sink and the housing.

22. An electronic device, comprising:
a heat generating component; and
the vapor chamber according to any one of claims 1 to 21, wherein
the vapor chamber is disposed on the heat generating component.

23. A chip package structure, comprising:
a substrate;
a chip, wherein the chip is disposed on the substrate; and
the vapor chamber according to any one of claims 1 to 21, wherein the vapor chamber is disposed on a side that is of the chip and that is away from the substrate.
